Europäisches Patentamt

European Patent Office

Office européen des brevets

(11) Veröffentlichungsnummer : **0 071 003**
**B1**

(12) # EUROPÄISCHE PATENTSCHRIFT

(45) Veröffentlichungstag der Patentschrift :
**09.10.85**

(21) Anmeldenummer : **82104977.2**

(22) Anmeldetag : **07.06.82**

(51) Int. Cl.⁴ : **C 23 C 20/04, C 23 C 18/38,
H 05 K 3/12**

(54) **Verfahren zur Herstellung von Leiterplatten.**

(30) Priorität : **30.07.81 DE 3130159**

(43) Veröffentlichungstag der Anmeldung :
**09.02.83 Patentblatt 83/06**

(45) Bekanntmachung des Hinweises auf die Patenterteilung : **09.10.85 Patentblatt 85/41**

(84) Benannte Vertragsstaaten :
**AT FR GB IT**

(56) Entgegenhaltungen :
**CH-A- 616 454
DD-A- 93 370
DD-A- 94 423
DE-A- 1 621 207
DE-B- 1 571 802
DE-B- 1 620 768
DE-B- 2 014 737**

(73) Patentinhaber : **PREH, Elektrofeinmechanische
Werke Jakob Preh Nachf. GmbH & Co.
Postfach 1740 Schweinfurter Strasse 5
D-8740 Bad Neustadt/Saale (DE)**

(72) Erfinder : **Ambros, Peter, Dipl.-Chem.
Am Wacholderrain 12
D-8741 Hohenroth/Leutershausen (DE)**
Erfinder : **Müller, Walter
Hauptstrasse 35
D-8741 Salz (DE)**

## Beschreibung

Die Erfindung betrifft ein Verfahren zur Herstellung von Widerstände und/oder Schaltkontaktstellen integriert enthaltenden Leiterplatten.

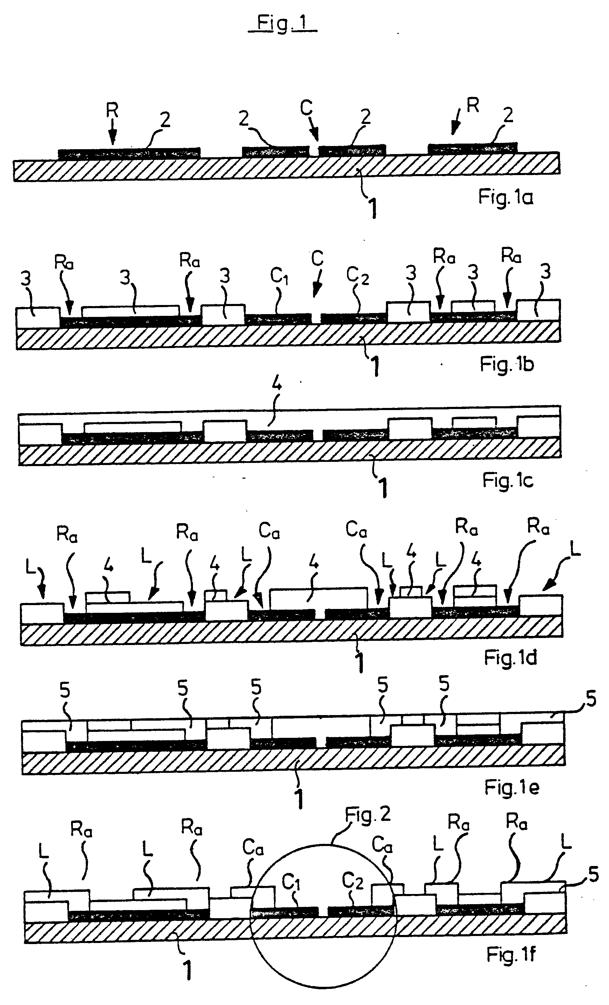

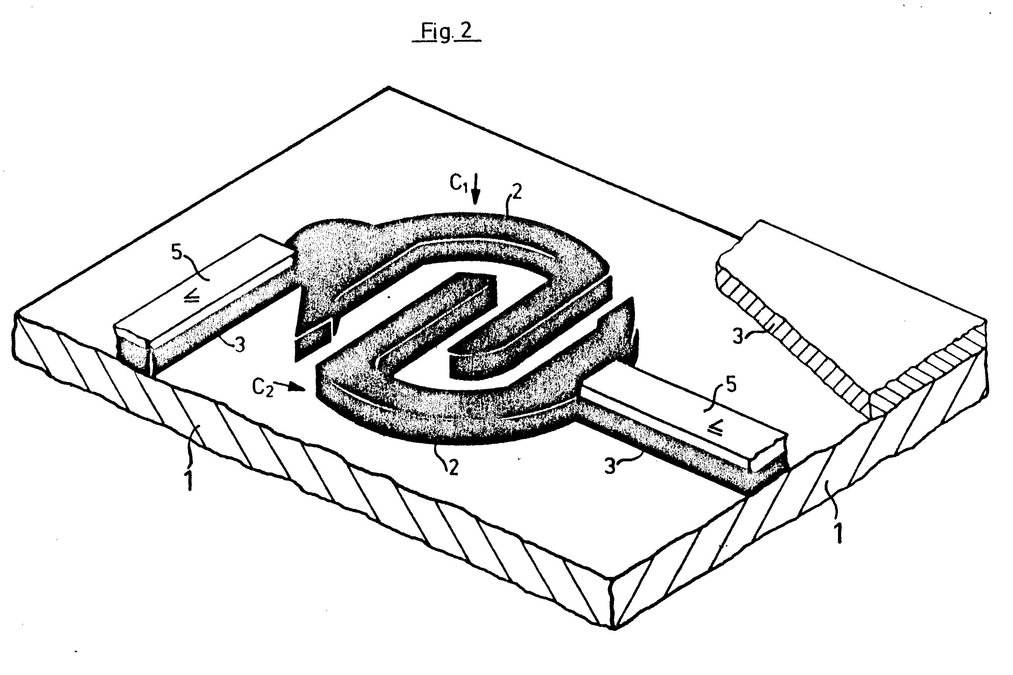

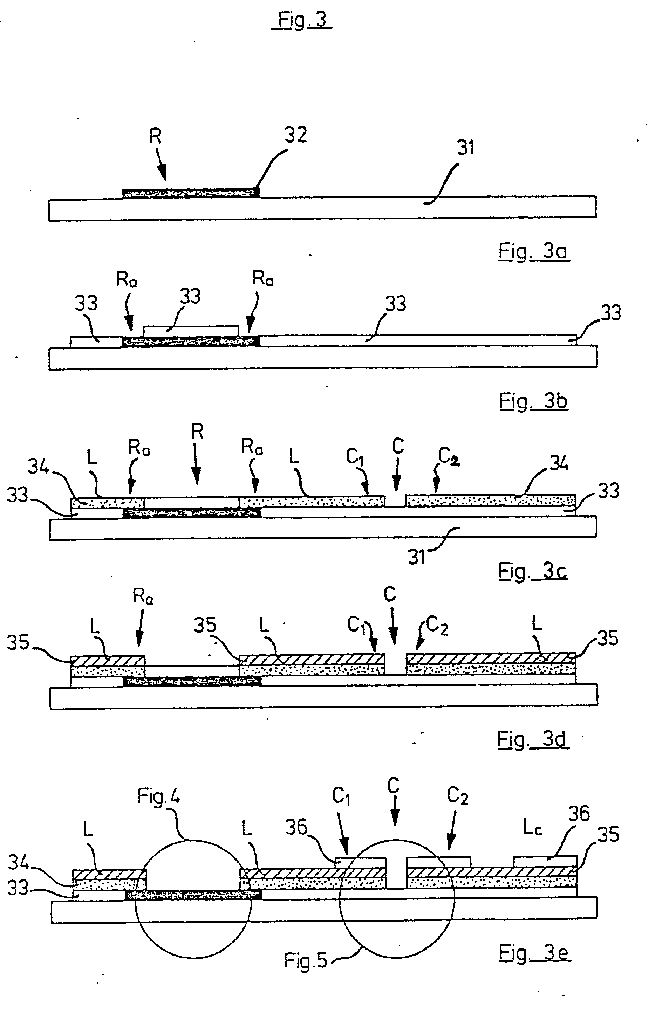

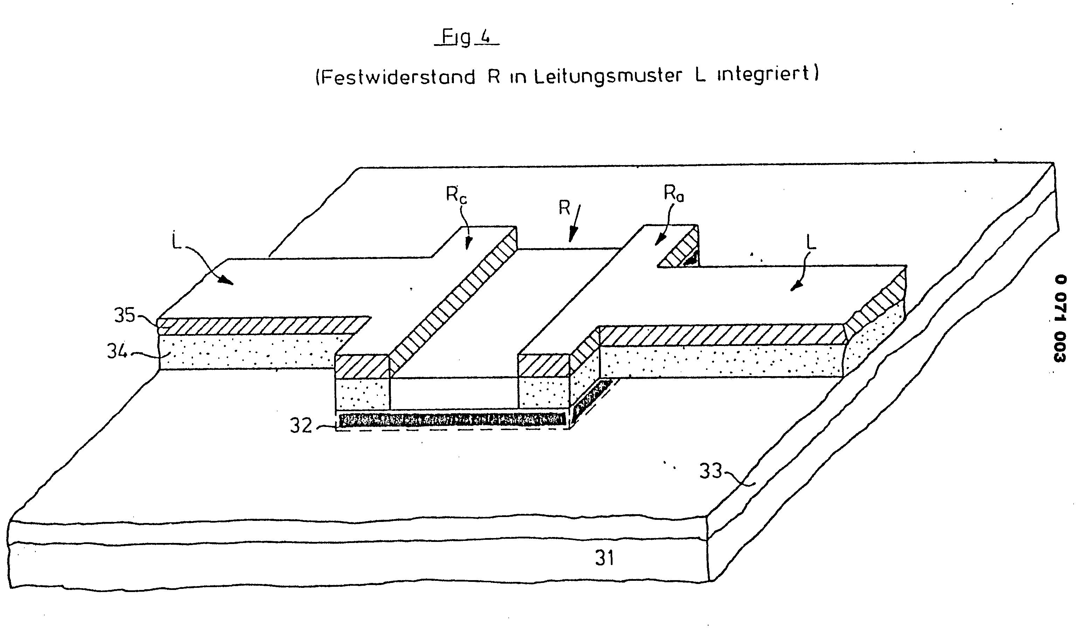

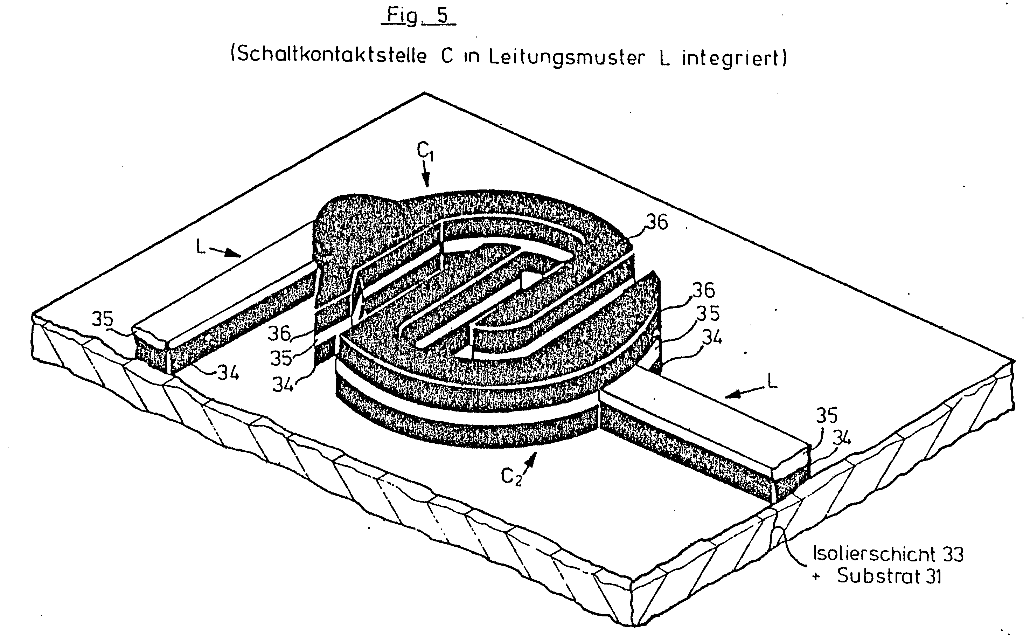

Im Zusammenhang mit der zunehmenden Bedeutung von Ein- und Ausgabe-Elementen oder Anzeigen, beispielsweise in Form von Kodier- und Dekodier-Schaltungen mit Eingabetastaturen von Rechnern oder dergleichen, besteht ein zunehmendes Bedürfnis, derartige Dekodierschaltungen, welche Leiterbahnen und Widerstandsnetzwerke enthalten, mit den Eingabetastaturen in möglichst weitgehend integrierter Weise herstellen zu können. Herstellungstechnisch bedeutet dies, daß ein erhöhtes Bedürfnis nach der Möglichkeit weitgehend integrierter Herstellung von Widerstände und Schaltkontaktstellen enthaltenden Leiterplatten besteht. Unter Schaltkontaktstellen sind dabei mit in die Leiterbahnkonfiguration einbezogenen Festkontakten ausgebildete Unterbrechungen der Leiterbahnen zu verstehen, welche durch mit den Festkontakten zusammenwirkende bewegliche Kontakte, die beispielsweise als Federkontakte oder bevorzugt als Gummimattenkontakte ausgebildet sein können, überbrückbar sind. Beispielshalber sei auf die Figuren 2 und 5 der Zeichnung verwiesen, welche in perspektivischer Draufsicht derartige (erfindungsgemäß hergestellte) Schaltkontaktstellen veranschaulichen.

Nach dem Stande der Technik sind bereits verschiedene Versuche zur Integration von Widerständen und gegebenenfalls auch von Schaltkontaktstellen in gedruckte Leiterplatten bekannt geworden. Bezüglich der Integration von Widerständen in Leiterplatten sei beispielsweise auf einen Übersichtsartikel « Siebgedruckte Leiterplatten mit Widerständen kombiniert » in « Sieb und Rakel », November 1978, Sn. 391-398, verwiesen.

So ist es im einzelnen bekannt, in durch Subtraktivtechnik hergestellte gedruckte Schaltungen (Leiterplatten) nachträglich Widerstandsten gemäß einem für die Widerstände gewünschten Layout mittels Siebdruck einzudrucken, vgl. beispielsweise « Widerstandsdruck auf Leiterplatten », ME, Jahrgang 45 (1979), Sn. 313-315. Die Widerstandspasten bestehen dabei im wesentlichen aus einem organischen Bindemittel, in das Ruß-, Graphit- oder Silberteilchen eindispergiert sind. Dieses bekannte Verfahren mit nachträglichem Eindruck von Widerstandsbereichen in Leiterbahnkonfigurationen von Leiterplatten, die beispielsweise in subtraktiver Ätztechnik aus mit Kupfer kaschierten Substratplatten hergestellt wurden, hat eine Reihe von Nachteilen : Der zum Aushärten der in die elektrische Schaltung eingedruckten Widerstandspaste verfügbare Temperaturbereich ist auf niedrige Werte begrenzt, da ansonsten die zuvor im Ätzverfahren hergestellten Kupfer-Leiterbahnen infolge einer Wärmedegradierung des Haftklebers der Kupferkaschierung ihre zunächst gute Haftung zum Substrat verlieren, wobei das Problem der Beeinträchtigung der Leiterbahnenhaftung am Substrat sich für zunehmende Feinheit der Leiterstrukturen besonders gravierend stellt. Infolge der Beschränkung auf verhältnismäßig niedrige Aushärttemperaturen ist keine optimale elektrische Stabilität der so erhaltenen Schaltung mit integrierten Widerständen erzielbar. An den Übergängen zwischen Leiterbahn und Widerstandsbereichen kann es infolge unterschiedlicher Ausdehnung der beiden Materialien leicht zu Rißbildungen kommen, die bis zu elektrischen Unterbrechungen führen können.

Ferner ist die Herstellung gedruckter Schaltungen mit integrierten Widerständen in der Weise bekannt, daß man zunächst ruß- oder graphithaltige Widerstandspasten mittels Siebdruck auf ein Hartpapiersubstrat aufdruckt und nach erfolgter thermischer Fixierung der einzelnen Widerstände diese untereinander mit einer Siebdruck-Leiterpaste, welche in einem organischen Bindemittel eindispergierte Silberpigmente enthält, untereinander verbindet. Die Höhe der Einbrenntemperatur wird dabei durch die maximal zulässige Einbrenntemperatur der Hartpapierunterlage limitiert, bei der noch keine Blasenbildung erfolgt und ein Verziehen oder Krümmen des Materials noch in zulässigen Grenzen gehalten wird. Ein schwerwiegender Nachteil der in dieser Weise hergestellten Schaltungen, die gegebenenfalls auch elektrische Kontaktstellen einschließen können, besteht darin, daß die mit Siebdruckpaste aufgedruckten elektrischen Leiterbahnen nicht lötbar sind und daß die so hergestellten Widerstände nicht mittels Laserstrahl abgleichbar sind : der Widerstandsdruck muß daher sehr genau, insbesondere mit sehr gleichmäßiger Schichtdicke erfolgen, was, wenn überhaupt, nur mit erheblichem Aufwand möglich ist.

Ein anderes bekanntes Verfahren zur Integrierung von Widerständen in Leiterplatten geht von der Verwendung eines Substratmaterials aus, das mit einer metallischen Widerstandschicht, zum Beispiel aus einer Cr/Ni-Legierung und einer darüberliegenden Kupferschicht kaschiert ist : die Leiterbahnen und die Widerstandsbereiche einer elektrischen Schaltung werden in subtraktiver Technik durch eine Differenzialätzung realisiert, vgl. « Bauteile Report », 16 (1978), Heft 3, Sn. 91-93, sowie auch Aufsatz von Horst W. Scheidt « Widerstände drucken mit Ohmega-Material » in Sonderdruck aus « Elektronik Packaging & Produktion », November 1976. Diese bekannte Technik hat zum einen den Nachteil, daß ein verhältnismäßig kostspieliges doppellagig kaschiertes Substratmaterial benötigt wird und daß zum anderen nur eine begrenzte Möglichkeit zur Variierung des spezifischen Widerstands der Cr/Ni-Widerstandsschicht besteht. Der jeweils gewünschte Widerstandswert für die einzelnen Widerstände muß daher in der Regel über die geometri-

sche Konfiguration des Widerstandes eingestellt werden, was insbesondere bei Schaltungen, für die eine hohe Packungsdichte gefordert wird, Schwierigkeiten bereitet.

Des weiteren sind auch Multilayer-Schaltungen mit integrierten elektrischen Kontaktstellen bekannt; bei dieser Technik wird jeweils die unterste Ebene des Multilayers im Subtraktiv-Verfahren hergestellt; die nächste(n) Ebene(n) wird/werden dann im sogenannten Semiadditiv- oder Volladditiv-Verfahren realisiert. Die gegebenenfalls integrierten Kontaktstellen müßen aber zusätzlich vernickelt und/oder vergoldet werden, um einen elektrisch sicheren, abrieb- und oxydationsbeständigen Kontakt zu gewährleisten. Diese zusätzlich erforderlichen Verfahrensschritte Vernickeln und/oder Vergolden der elektrischen Kontaktstellen sind kostspielig und zeitaufwendig. Außerdem ermöglicht diese Verfahrensart nicht die gleichzeitige Integrierung elektrischer Widerstände.

Der Erfindung liegt daher als Aufgabe die Schaffung eines Verfahrens zugrunde, das ausgehend von einfachem, billigem unkaschiertem Substratmaterial in rein additivem Verfahren die integrierte Herstellung von Widerstände und/oder Schaltkontaktstellen enthaltenden Leiterplatten ermöglicht, bei dem keine engen Beschränkungen hinsichtlich der Einbrenntemperaturen für die Aushärtung der Widerstandsschichten bestehen, eine gute Haftung der Leiterbahnen gewährleistet ist und die Leiterbahnen in lötbarem Zustand erhalten werden.

Zu diesem Zweck ist gemäß der Erfindung vorgesehen, daß im additiven Verfahren zunächst die Widerstände und/oder die Schaltkontaktstellenbereiche im gewünschten Layout aus einer für nachfolgende stromlose Metallisierung sensibilisierten Widerstandspaste aufgedruckt, sodann eine für nachfolgende stromlose Metallisierung sensibilisierte Haftvermittlerschicht in einem für die Leiterbahnen und/oder für die Schaltkontaktstellen gewünschten Layout aufgebracht wird, und daß sodann durch Behandeln der Platte in einem chemisch arbeitenden Metallisierungsbad die freiliegenden Bereiche der Haftvermittlerschicht stromlos metallisiert werden, unter Erzeugung der Leiterbahnen und/oder der Schaltkontaktstellen in dem gewünschten Layout. Eine bevorzugte Ausführungsform, die sich zur Herstellung von Widerstände und/oder Schaltkontaktstellen integriert enthaltenden Leiterplatten mit Feinleiterstruktur der Leiterbahnen unter Anwendung von Photodruckverfahren zur Delineation des Layouts der Leiterbahnen eignet, ist Gegenstand des Anspruchs 4. Eine ebenfalls vorteilhafte Ausführungsform, die sich zur Herstellung von Widerstände und/oder Schaltkontaktstellen integriert enthaltenden Leiterplatten mit einer die Delineation des Leiterbahnenlayouts im Siebdruckverfahren gestattenenden Leiterbahnenstruktur eignet, ist Gegenstand des Anspruchs 7.

Indem nach dem Grundgedanken der Erfindung zunächst die Widerstände (und gegebenenfalls auch die Schaltkontaktstellenbereiche) mittels einer Widerstandspaste aufgedruckt werden und im weiteren Verlauf eine für spätere stromlose Verkupferung sensibilisierte Haftvermittlerschicht entsprechend der für die Leiterbahnen (sowie gegebenenfalls für die Schaltkontaktstellen) gewünschten Layoutkonfiguration aufgebracht wird, deren freiliegende Bereiche in einem nachfolgenden Verfahrensschritt stromlos metallisiert werden, wird bei insgesamt voll-additiver Arbeitsweise eine gegenseitige Behinderung bei der Realisierung der Widerstandsbereiche einerseits und der Leiterbahnen und Schaltkontaktstellen andererseits vermieden, derart daß die Widerstände mit einer hohen, eine optimale elektrische Stabilität gewährleistenden Einbrenntemperatur ausgehärtet werden können, ohne daß hierdurch die Haftung der Leiterbahnen beeinträchtigt wird. Die Leiterbahnen (einschließlich der Kontaktierungen der Widerstandsanschlußbereiche) und gegebenenfalls die metallisierten Schaltkontaktstellen werden in einer lötfähigen Ausführung erhalten und weisen aufgrund ihrer Erzeugung durch stromlose Metallisierung einer entsprechend sensibilisierten Haftvermittlerschicht eine ausgezeichnete Haftung an der Substratunterlage und ausgezeichnete Allgemeineigenschaften auf. Die Haftvermittlerunterlage der Leiterbahnen kann je nach der Gestaltung im einzelnen aus einem elektrisch isolierenden Material oder vorzugsweise auch aus einem elektrisch leitenden, niederohmigen Widerstandsmaterial bestehen, wobei im zweiten Fall selbst bei Auftreten von Rißbildungen oder sonstigen Diskontinuitäten in der eigentlichen metallischen Leiterbahn durch die Überbrückung der darunterliegenden Haftvermittlerschicht eine Leitungsunterbrechung vermieden würde. Das erfindungsgemäße Verfahren eignet sich wie dargelegt sowohl zur Herstellung von Leiterplatten mit Feinleiterstruktur als auch zur Herstellung von Platten mit einer im Siebdruck realisierbaren Konfiguration des Leiterbahnenlayouts, wobei jedoch in jedem Falle die Metallisierungen der Leiterbahnen in jedem Falle nicht im Siebdruckverfahren sondern durch stromlose Metallisierung von entsprechend sensibilisierten haftvermittelnden Unterlageschichten realisiert werden.

Die in die Schaltung integrierten Festkontakte der Schaltkontaktstellen können bei dem erfindungsgemäßen Verfahren entweder metallisch oder in einer elektrisch leitenden, niederohmigen Pyropolymer-Widerstandspaste ausgeführt werden, die nach Aushärtung hoch abriebfeste und oxydationsbeständige Kontaktbereiche bildet. Auch bei metallischer Ausführung der Schaltkontaktstellen können diese oberflächig mit einem Überzug aus der erwähnten niederohmigen Pyropolymerschicht versehen werden, als Abrieb- und Oxydationsschutz. In beiden Fällen kann auf diese Weise die ansonsten erforderliche Vergoldung oder Vernickelung derartiger Schaltkontaktstellen erübrigt werden.

In der gleichen Technik wie die Schaltkontaktstellen können bei dem erfindungsgemäßen Verfahren auch ausgewählte Bereiche der Leiterbahnen, beispielsweise an den Rändern der Leitungsplatte befindliche Kontaktbereiche zur Kontaktierung mittels aufschiebbarer Steckleisten oder dergleichen ausgebildet werden.

Ein weiterer wesentlicher Aspekt der Erfindung besteht darin, daß zur Erzeugung der elektrisch leitenden Widerstandsschichten, der elektrisch isolierenden Abdeckschichten und/oder der Haftvermittlerschichten Pasten verwendet werden, die auf einer gemeinsamen, einheitlichen Bindemittelgrundsubstanz aufgebaut und entsprechend der jeweiligen Funktion als Widerstand, Isolierschicht und/oder Haftvermittler modifiziert sind. Hierdurch wird ein annähernd angeglichenes Ausdehnungs- und Schrumpfverhalten der einzelnen vorstehend erwähnten funktionellen Schichten erreicht, wodurch innere Spannungen zwischen den einzelnen Schichtsystemen weitgehend verringert werden.

Nach einer bevorzugten Ausgestaltung der Erfindung ist vorgesehen, daß die einheitliche Bindemittelgrundsubstanz ein organisches Bindemittelsystem auf der Grundlage eines gesättigten Polyesters und Isoporondiisocyanat und einer weiteren Bindemittelkomponente aufweist und neben OH-Gruppen blockierte bzw. maskierte Isocyanatgruppen und einen Epoxydharzanteil enthält.

Für aus chemischen Bädern metallisierbare, beispielsweise verkupferbare und/oder vernickelbare Widerstandsschichten und/oder dielektrische Haftvermittlerschichten eignet sich vorteilhaft eine Rindemittelgrundsubstanz, die als erwähnte weitere Bindemittelkomponente ein hydroxymethylgruppenhaltiges Acrylamidharz und ein Melaminformaldehydalkydharz enthält. Zur Herstellung hervorragend elektrisch isolierender, für Wasser und Wasserdampf undurchlässiger Beschichtungen bzw. als Lötstopplack eignet sich vorzugsweise eine Bindemittelgrundsubstanz, die als die weitere Bindemittelkomponente Polyisocyanat vernetzende Acrylharze und/oder Polyvinylacetalharze enthält.

Zur Herstellung von Widerstands- und gegebenenfalls Haftvermittlerschichten kann eine Widerstandspaste verwendet werden, welche in an sich bekannter Weise Pyropolymer-, Ruß-, Graphit-, Silber- oder Nickelteilchen mit Teilchengrößen kleiner als 6 µm eindispergiert enthält.

Nach einem wesentlichen Aspekt der Erfindung erfolgt die Erzeugung der metallisierten Leiterbahnen und gegebenenfalls Schaltkontaktstellen durch stromlose Metallisierung von auf der Platte in entsprechender Konfiguration erzeugten Widerstands-, Isolier- und/oder Haftvermittlerschichten, welche für eine derartige stromlose Metallisierung katalytisch sensibilisiert sind. Die zur Herstellung dieser Schichten dienende Paste enthält einen in die Bindemittelgrundsubstanz eindispergierten Sensibilisierungskatalysator für die nachfolgende stromlose Metallisierung ; als Katalysatorbestandteil eignen sich Elemente der Gruppen I und VIII des Periodischen Systems, vorzugsweise in Form organischer oder anorganischer reduzierbarer Verbindungen dieser Elemente, beispielsweise Katalysatorsubstanzen wie Pd, PdCl oder $Cu_2O$. Der Katalysatorbestandteil kann vorteilhaft feuerfeste, gegebenenfalls mit pyrolytischem Kohlenstoff überzogene Trägerteilchen beispielsweise aus $Al_2O_3$, aufweisen, die mit der genannten Katalysatorverbindung bekeimt oder überzogen sind, beispielsweise in Gestalt eines kolloidalen Niederschlags der Katalysatorverbindungen auf den Trägerteilchen.

Die im Bindemittel eindispergierten Katalysatorteilchen müssen durch ein chemisches « Aufrauhen » der Bindemitteloberfläche, das heißt durch einen porösen Aufschluß der Bindemitteloberfläche, zum Teil freigelegt werden, derart, daß die Sensibilisierungskatalysatoren in einem autokatalytisch arbeitenden Metallisierungsbad für die stromlose Metallabscheidung aktiv werden können. Diese chemische « Aufrauhungs »-Vorbehandlung erfolgt beispielsweise durch Einwirken von verdünnter Schwefelsäure, welche Komponenten des Bindemittles herauslöst und so ein Porenlabyrinth in der Oberfläche der Bindemittelschicht erzeugt. Dieses durch die Schwefelsäureeinwirkung entstandene Porensystem dient gleichzeitig einer Verkeilung der im Metallisierungsbad aufgewachsenen Metallschicht, wodurch eine außerordentlich gute Haftung der Metallschicht an der Haftvermittlerschicht erreicht wird, die ihrerseits wieder eine sehr gute Adhäsion zum Substratmaterial besitzt. Für diese durch Schwefelsäure einwirkung chemisch aufrauhbaren Isolier- oder Widerstandsschichten eignet sich bevorzugt das oben bereits erwähnte Bindemittelsystem, das als weitere Bindemittelkomponente ein hydroxymethylgruppenhaltiges Acrylamidharz und ein Melaminformaldehydalkydharz enthält. Umgekehrt eignet sich ein Bindemittelsystem, bei dem in der oben erwähnten Weise diese Bindemittelkomponente durch Polyisocyanat vernetzende Acrylharze und/oder Polyvinylacetalharze ersetzt ist und gleichzeitig der Epoxydharzanteil der Bindemittelgrundsubstanz erhöht ist, bevorzugt zur Erzeugung einer elektrisch hervorragend isolierenden, gegenüber 20-30 %iger Schwefelsäure resistenten, wasser- und wasserdampfundurchlässigen Schicht, die im chemisch arbeitenden Metallisierungsbad nicht angegriffen wird und eine gute Temperaturbeständigkeit aufweist.

Im Folgenden werden Ausführungsbeispiele der Erfindung anhand der Zeichnung beschrieben ; in dieser zeigen :

Figur 1 die Herstellung einer eine Feinleiterstruktur aufweisenden Leiterplatte mit integrierten Festwiderständen und integrierten Schaltkontakten, gemäß einer ersten Ausführungsform, wobei die Teilfiguren 1a-1f verschiedene aufeinanderfolgende Stadien des Herstellungsverfahrens veranschaulichen.

Figur 2 in schematischer perspektivischer Draufsicht einen eine Schaltkontaktstelle enthaltenden Teil der nach dieser Ausführungsform erhaltenen Leiterplatte.

Figur 3 die Herstellung einer Leiterplatte ohne Feinleiterstruktur mit integrierten Festwiderständen und Schaltkontaktstellen, gemäß einer anderen, vereinfachten Ausführungsform der Erfindung mit Delineation des Leiterbahnenlayouts im Siebdruckverfahren, wobei die Teilfiguren 3a-3e wiederum verschiedene Stadien im Verlauf des Herstellungsvorgangs veranschaulichen.

Figur 4 in schematischer perspektivischer Draufsicht einen Bereich der nach dem Verfahren gemäß Figur 3 hergestellten Leiterplatte mit einem in das Leitungsmuster integrierten Festwiderstand.

Figur 5 in entsprechender perspektivischer Draufsicht einen eine in das Leitungsmuster integrierte Schaltkontaktstelle aufweisenden Bereich der gemäß Figur 3 hergestellten Leiterplatte.

Im Folgenden wird zunächst anhand der Figuren 1 und 2 eine erste Ausführungsform der erfindungsgemäßen Herstellung einer Leiterplatte mit integrierten Festwiderständen und integrierten Schaltkontakten beschrieben, wobei das Leitungsmuster eine so feine Struktur aufweist, daß für die Delineation des Leitungsmusters Photodruckverfahren erforderlich sind. Im einzelnen veranschaulicht Figur 1 in ihren Teilfiguren 1a-1f verschiedene aufeinanderfolgende Stadien des Herstellungsverfahrens, während Figur 2 in schematischer perspektivischer Draufsicht einen eine Schaltkontaktstelle C enthaltenden Teil der Leiterplatte zeigt.

Ausgehend von einem Substrat 1 aus Phenolharz-, Epoxydharz-, Polyimidharz-Hartpapier oder im Spritzgußverfahren hergestellten Kunststoffsubstraten aus Polyphenylenoxid, Polyphenylensulfid, Polyimid, Polyamidimid oder Polyphenylensulfon wird in einem ersten Verfahrensschritt gemäß Figur 1a im Siebdruckverfahren eine für spätere stromlose Verkupferung sensibilisierte Widerstandspaste 2 aufgedruckt, und zwar in einem den gewünschten Festwiderständen R sowie den gewünschten Kontaktstellen C entsprechenden Layout bzw. Muster. Die nach diesem Muster aufgedruckte Widerstandspaste wird sodann je nach Substratart bei Temperaturen im Bereich von ca. 200°-ca. 250 °C ausgehärtet.

In einem zweiten, in Figur 1 b veranschaulichten Verfahrensschritt wird sodann die gesamte Substratplatte im Wesentlichen ganzflächig mit einem ebenfalls für spätere stromlose Verkupferung sensibilisierten Abdeckisolierlack 3 abgedeckt, wobei jedoch die Anschlußbereiche $R_a$ der im Verfahrensschritt gemäß Figur 1a hergestellten Widerstände R sowie die ebenfalls im Verfahrensschritt von Figur 1a hergestellten Kontaktstellen C (einschließlich ihrer Anschlußbereiche) ausgespart werden. Zu diesem Zweck erfolgt die Beschichtung mit dem Abdeckisolierlack 3 im Siebdruckverfahren. Am Ende dieses Verfahrensschrittes sind damit, wie in Figur 1b ersichtlich, die im ersten Verfahrensschritt aufgedruckten und fixierten Widerstände R (mit Ausnahme ihrer Anschlußbereiche $R_a$) sowie die übrigen Teile der Platte (mit Ausnahme der Kontaktstellen C als ganzer) mit dem (katalytisch verkupferbaren) Abdeckisolierlack 3 maskiert.

In einem nächsten Verfahrensschritt (Figur 1c) wird sodann die Substratplatte als Ganzes ganzflächig mit einem (festen oder flüssigen) Photoresist- oder Photoabdeckerfilm 4 beschichtet und dieser sodann (vergleiche Figur 1d) in bekannter Weise gemäß dem für die Feinleiterstruktur einschließlich der Widerstandsanschlußbereiche $R_a$ sowie der Anschlußbereiche $C_a$ der Kontaktstellen gewünschten Muster oder Layout selektiv belichtet und entschichtet (vergleiche Figur 1d). Am Schluß dieses Verfahrensschrittes (das heißt in dem in Figur 1d gezeigten Gebilde) liegen somit die folgenden, nicht von Photoabdecker 4 bedeckten Bereiche offen : Die für die Leiterpfade vorgesehenen Bereiche L, die Widerstandsanschlußbereiche $R_a$, die Anschlußbereiche $C_a$ der Kontaktstellen C.

Im anschließenden vierten Verfahrensstadium (Figur 1e) werden nun diese nicht maskierten Bereiche, an welchen somit entweder Teile der verkupferbaren Widerstandsschicht 2 oder der verkupferbaren Isolierschicht 3 freiliegen, im chemisch arbeitenden Kupferbad stromlos verkupfert (wie bei 5 in Figur 1e angedeutet). Hierbei entstehen die Leiterbahnen ·L entsprechend dem gewünschten Feinleiter-Layout, die Widerstandsanschlüsse $R_a$ sowie die Anschlüsse $C_a$ der Kontaktstellen C.

Nach anschließendem Strippen der Photoabdeckerschicht 4 und Abdecken der so erhaltenen Schaltungsplatte mit einem Lötstopplack (unter Aussparung der elektrischen Kontaktstellen C) erhält man so die fertige Schaltungsplatte mit in voll integrierter Technik hergestellten Festwiderständen R und Kontaktstellen C, wie in Figur 1f veranschaulicht.

Wie bereits weiter oben erwähnt, sind unter « Schaltkontaktstellen » in erster Linie wie in Figur 2 veranschaulicht Unterbrechungen im Zuge der Leiterpfade der Schaltungsplatte zu verstehen, welche mit (nicht dargestellten) äußeren beweglichen Schalt-Überbrückungskontakten zusammenwirken. In der schematischen perspektivischen Draufsicht von Figur 2 sind die beiden in die Schaltung integrierten Schaltstellenfestkontakte C1 und C2 in näherem Detail wiedergegeben ; in Figur 1 sind diese beiden Festkontakte nur vereinfacht schematisch angedeutet. (Umgekehrt ist in Figur 2 die Schicht aus dem verkupferbaren Abdeckisolierlack 3 der Einfachheit und Übersichtlichkeit halber nur bruchstückweise angedeutet).

Bei der in den Figuren 1 und 2 gezeigten Ausführungsform bestehen die beiden Festkontakte C1 und C2 der Kontaktstelle aus dem Material der ausgehärteten Widerstandspaste 2. Diese Paste ist, wie bereits erwähnt, im ausgehärteten Zustand nicht nur elektrisch leitfähig, sondern auch sehr abriebfest. Dadurch weisen die Festkontakte C1 und C2 der Kontaktstelle eine nicht oxydierende und somit elektrisch und mechanisch zuverlässige Oberfläche auf, so daß eine sonst erforderliche Vernickelung oder Vergoldung dieser Kontaktstellen entfallen kann. Im Zusammenwirken mit dem (nicht dargestellten) beweglichen Überbrückungskontakt weist die Kontaktstelle im geschlossenen, überbrückten Zustand eine ausreichende Leitfähigkeit auf. Gegebenenfalls könnte jedoch gemäß einer weiter unten anhand der Figuren 3 und 5 erläuterten Ausführungsform auch eine Verkupferung der Kontaktstellen C1 und C2 vorgesehen werden (wobei zu diesem Zweck im Verfahrensstadium gemäß Figur 1d die Kontaktstelle C von dem Photoabdeckermaterial 4 mit entschichtet werden müßte) ; die verkupferten Festkontakte C1 und C2 könnten anschließend noch mit einer oberflächigen Beschichtung aus der Widerstandspaste versehen werden, zur Gewährleistung der erforderlichen Abriebfestigkeit und Oxydationsbeständigkeit. In diesem Fall läge im Schließzustand der Kontaktstelle lediglich die geringe Schichtdicke dieser Widerstandsbeschichtung im elektrischen Stromweg, deren Widerstand praktisch vernachlässigt werden kann.

Im Folgenden wird nun anhand der Figuren 3-5 eine vereinfachte Ausführungsform des erfindungsgemäßen Verfahrens beschrieben, die in Fällen Anwendung finden kann, wo das gewünschte Leitermuster keine Feinleiterstruktur aufweist und daher zur Delineation des Leiter-Layouts auf Photodruckverfahren verzichtet und mit Siebdruck gearbeitet werden kann. Figur 3 veranschaulicht mit ihren Teilfiguren 3a-3e wiederum verschiedene Stadien während des Herstellungsvorgangs.

Gemäß Figur 3a wird — ausgehend wiederum von einem Substrat 31 der allgemeinen Art wie oben für die Ausführungsform nach Figur 1 beschrieben — dieses Siebdruckverfahren mit einer Widerstandspaste, beispielsweise einem Pyropolymer mit eingelagerten Ruß-, Graphit-, Silberoder Nickelteichen, bedruckt. In Abweichung von der Ausführungsform nach Figur 1 ist jedoch diese Widerstandspaste nicht für nachträgliche Verkupferung sensibilisiert, und das Muster umfaßt nur die für die Festwiderstände R gewünschten Bereiche. Die Widerstandspaste wird beispielsweise 5 Minuten lang bei 185 °C angetrocknet. In diesem Siebdruckschritt werden somit zunächst nur die Festwiderstände R aufgedruckt.

In einem in Figur 3b veranschaulichten zweiten Verfahrenschritt wird wiederum die Leiterplatte als Ganze im wesentlichen ganzflächig mit einer Abdeck-Isolierpaste 33 im Siebdruck beschichtet, wobei lediglich die Widerstandsanschlußbereiche $R_a$ ausgespart werden. Im Unterschied zur Ausführungsform nach Figur 1 ist dabei auch dieser Isolierabdecklack nicht für chemische Verkupferung sensibilisiert. Das aufgedruckte Isolierabdeckmaterial 33 wird beispielsweise wiederum bei 185 °C 5 Minuten lang angetrocknet.

Im folgenden Verfahrensschritt gemäß Figur 3c wird sodann im Siebdruckverfahren eine für spätere stromlose chemische Verkupferung sensibilisierte, elektrisch leitfähige, niederohmige Haftvermittler-Widerstandspaste 34 aufgedruckt. Das Layout-Muster für den Aufdruck dieser sensibilisierten Widerstandspaste 34 umfaßt einerseits die für die Leiterbahnen L gewünschten Bereiche, die sich auch auf die im vorhergehenden Verfahrensschritt gemäß Figur 3b ausgesparten, nicht mit dem Isolierlack 33 bedeckten Anschlußbereiche $R_a$ der Widerstände R erstrecken, sowie die Schaltkontaktstellen C, deren Festkontakte in Figur 3c bei $C_1$ und $C_2$ angedeutet sind.

Das in dieser Weise additiv mit den Schichten 32, 33, 34 bedruckte System wird anschließend bei ca. 230 °C eine Stunde lang ausgehärtet. Die Bedruckung mit der verkupferbaren Widerstandspastenschicht 34 erfolgt dabei in der Weise, daß sie nach dem Aushärten des Gebildes beispielsweise eine Schichtdicke von ca. 15 µm besitzt.

In einem folgenden vierten Verfahrensschritt gemäß Figur 3d werden sodann im chemisch arbeitenden Kupferbad die mit der sensibilisierten Haftvermittlerwiderstandspaste 34 bedruckten Bereiche (das heißt also die Leiterpfade L nebst Widerstandsanschlußbereichen $R_a$ zur Kontaktierung der Widerstände R, sowie die Festkontakte $C_1$, $C_2$ der Schaltkontaktstellen C) verkupfert, und zwar mit einer Kupfer schicht 35 von ca. 10-15 µm Schichtdicke. In diesem Verfahrensschritt werden somit durch Verkupferung der Haftvermittler-Widerstandsschicht 34 lötbare Leiterbahnen L (nebst den Anschlußbereichen $R_a$ der Widerstände R) und die Schaltkontaktstellen C mit ihren Festkontakten $C_1$, $C_2$ hergestellt.

In einem nachfolgenden Verfahrensschritt gemäß Figur 3e werden sodann die verkupferten Kontaktstellen C, und gegebenenfalls auch die Leiterbahnen oder bestimmte Teile der Leiterbahnen, mit einer niederohmigen Pyropolymer-Widerstandspaste 36 bedruckt. Im gezeigten Ausführungsbeispiel ist diese Bedruckung mit der niederohmigen Pyropolymerschicht 36 im Bereich der Schaltkontaktstelle C sowie in dem rechts gelegenen Teil Lc einer Leiterbahn dargestellt, bei der es sich beispielsweise um einen außen am Rand gelegenen. Bereich für Steckkontaktverbindungen mit aufschiebaren Steckerleisten handeln kann. Diese Pyropolymer-Widerstandspaste verleiht, nach Aushärtung von beispielsweise 10 Minuten bei ca. 185 °C, den so bedruckten Bereichen (das heißt den Schaltkontaktstellen C und gegebenenfalls den Bereichen $L_c$ der Leiterbahnen für Steckkontaktierung) eine hohe Abriebfestigkeit und die für eine sichere Kontaktierung erforderliche Oxydationsbeständigkeit, derart, daß die ansonsten erforderliche gesonderte Vernickelung oder Vergoldung dieser Bereiche entfallen kann.

Figur 4 veranschaulicht in schematischer perspektivischer Draufsicht einen Bereich der in dieser Weise hergestellten Schaltungsplatte mit einem in das Leitungsmuster L integrierten Festwiderstand R, wobei die Leiterbahnen L den Widerstand R in den Widerstandsanschlußbereichen $R_a$ überlappen.

Figur 5 veranschaulicht in entsprechender perspektivischer Draufsicht einen Bereich der gemäß dieser Ausführungsform hergestellten Schaltungsplatte mit einer in das Leitungsmuster L integrierten Schaltkontaktstelle C mit Festkontakten $C_1$ und $C_2$; wie ersichtlich sind die Festkontakte der Kontaktstelle C bei dieser Ausführung in der erwähnten Weise oberflächig über der Verkupferung 35 durch abschliessende Bedruckung mit der niederohmigen Pyropolymerpaste 36 als Abrieb- und Oxydationsschutz versehen. Durch die ganzflächige Verkupferung 35 der Festkontakte $C_1$, $C_2$ ergibt sich eine besonders niederohmige Ausführung der Schaltkontaktstellen. In dem durch einen (nicht dargestellten) äußeren beweglichen Kontakt überbrückten Schließzustand der Schaltkontaktstelle liegt lediglich die geringe Schichtdicke der oberflächigen Bedruckung mit der Pyropolymerpaste 36 im elektrischen Stromweg, deren Widerstand praktisch vernachlässigt werden kann.

Der vorstehend anhand zweier bevorzugter Ausführungsformen gemäß den Figuren 1 und 2, bzw. 3-5 erläuterte additive Aufbau von Widerstände und/oder Schaltkontaktstellen enthaltenden Leitungsplatten kann gegebenenfalls durch wiederholte Ausführung der Verfahrensschritte gemäß Figur 1 bzw. gemäß Figur 3 ein- oder beidseitig des Substrates beliebig fortgesetzt werden, wobei die verschiedenen Ebenen in an sich bekannter Weise durch Isolierschichten, gegebenenfalls mit gewünschten Durchkontaktierungen, voneinander getrennt würden.

Die Erfindung wurde vorstehend anhand bevorzugter Ausführungsformen erläutert, die jedoch selbstverständlich in Einzelheiten in mannigfacher Weise abgewandelt werden können. Insbesondere sind wechselseitige Kombinationen der beiden anhand der Figuren 1 und 3 erläuterten Ausführungsformen des erfindungsgemäßen Verfahrens je nach der Gestaltung des Einzelfalles möglich. Wesentlich für den Grundgedanken der Erfindung ist die auf die anfängliche Herstellung von Widerständen im Siebdruck folgende Erzeugung einer für nachfolgende stromlose Metallisierung sensibilisierten Haftvermittlerunterlage für die Leiterbahnen und gegebenenfalls die Schaltkontaktstellen in dem für das Leitungsmuster und die Schaltkontaktstellen erforderlichen Layout, mit nachfolgender stromloser Metallisierung der freiliegenden Bereiche dieser sensibilisierten Haftvermittlerschicht.

## Patentansprüche

1. Verfahren zur Herstellung von Widerständen und/oder Schaltkontaktstellen integriert enthaltenden Leiterplatten, dadurch gekennzeichnet, daß im additiven Verfahren zunächst die Widerstände (R) und/oder die Schaltkontaktstellenbereiche (C) im gewünschten Layout aus einer für nachfolgende stromlose Metallisierung sensibilisierten Widerstandspaste (2, 32) auf ein Substrat aufgedruckt, sodann eine für nachfolgende stromlose Metallisierung sensibilisierte Haftvermittlerschicht (3, 34) in einem für die Leiterbahnen (L) und/oder für die Schaltkontaktstellen (C) gewünschten Layout auf das Substrat aufgebracht wird, und daß sodann durch Behandeln der Leiterplatte in einem chemisch arbeitenden Metallisierungsbad die freiliegenden Bereiche der Haftvermittlerschicht (3, 34) stromlos metallisiert werden, unter Erzeugung der Leiterbahnen (L) und/oder der Schaltkontaktstellen in dem gewünschten Layout.

2. Verfahren nach Anspruch 1, dadurch gekennzeichnet, daß die Haftvermittlerschicht aus einer elektrisch isolierenden Abdeckerpaste (3) hergestellt wird und außer als Haftvermittlerunterlage für die Leiterbahnen (L) auch zur Abdeckung der Widerstandsbereiche (R) dient.

3. Verfahren nach Anspruch 1, dadurch gekennzeichnet, daß die für stromlose Metallisierung sensibilisierte, als Haftvermittlerunterlage für die Leiterbahnen dienende Haftvermittlerschicht aus einer elektrisch leitenden niederohmigen Widerstandspaste (34) hergestellt wird und daß vor der Aufbringung dieser sensibilisierten Haftvermittlerschicht das mit den Widerständen (R, 32) bedruckte Substrat (31) im wesentlichen ganzflächig mit einer nicht-sensibilisierten isolierenden Abdeckerschicht (33) unter Aussparung der Widerstandsanschlußbereiche ($R_a$) beschichtet wird, welche als Abdeckung für die Widerstände (R, 32) und als Unterlage für die sensibilisierte Haftvermittlerschicht (34) dient.

4. Verfahren nach Anspruch 1 oder 2 zur Herstellung von Widerständen und/oder Schaltkontaktstellen integriert enthaltenden Leiterplatten mit Feinleiterstruktur der Leiterbahnen unter Anwendung von Photodruckverfahren zur Delineation des Layouts der Leiterbahnen, gekennzeichnet durch die folgenden Verfahrensschritte:

a) Bedrucken des Substrats (1) mit einer für nachfolgende stromlose Metallisierung sensibilisierten Widerstandspaste (2) in einem den gewünschten Widerstandsbereichen (R) und Kontaktstellenbereichen (C) entsprechenden Layout,

b) im wesentlichen ganzflächiges Bedrucken der Platte mit einer ebenfalls für nachfolgende stromlose Metallisierung sensibilisierten isolierenden Haftvermittler-Abdeckerpaste (3) unter Aussparung der Widerstandsanschlußbereiche ($R_a$) und der Kontaktstellenbereiche (C),

c) ganzflächige Beschichtung des Substrates mit einem Photoresist oder -abdecker (4) mit nachfolgender selektiver Belichtung und Entschichtung gemäß dem für die Leiterbahnen (L), die Widerstandsanschlußbereiche ($R_a$) und die Anschlußbereiche ($C_a$) der Kontaktstellen (C) gewünschten Layout,

d) Behandlung der Leiterplatte im chemisch arbeitenden Metallisierungsbad zur stromlosen Metallisierung der freiliegenden Bereiche der im Verfahrensschritt b) aufgebrachten sensibilisierten isolierenden Abdeckerschicht (3) und der im Verfahrensschritt a) aufgebrachten sensibilisierten Widerstandsschicht (2) unter additiver Erzeugung lötbarer Leiterbahnen (L) mit Widerstandsanschlußbereichen ($R_a$) und Kontaktstellen-Anschlußbereichen ($C_a$).

5. Verfahren nach Anspruch 4, dadurch gekennzeichnet, daß im Anschluß an den Verfahrensschritt a) eine Wärmebehandlung bei Temperaturen im Bereich von etwa 200 °C bis etwa 250 °C je nach Substratart zum Aushärten der Widerstandspaste (2) vorgenommen wird.

6. Verfahren nach Anspruch 4 oder 5, dadurch gekennzeichnet, daß in dem Verfahrensschritt c) auch die den gewünschten Schaltkontaktstellen entsprechende Bereiche (C) durch entsprechende selektive Belichtung und Entschichtung von dem Photoresist (4) freigelegt, in dem anschließenden Verfahrensschritt d) metallisiert und in einem abschließenden Verfahrensschritt mit einer elektrisch leitenden niederohmigen Pyropolymerschicht als Abrieb- und Oxydationsschutz bedruckt werden.

7. Verfahren nach Anspruch 1 oder 3, zur Herstellung von Widerständen und/oder Schaltkontaktstellen integriert, enthaltenden Leiterplatten mit einer die Delineation des Leiterbahnenlayouts im Siebdruckverfahren gestattenden Leiterbahnenstruktur, gekennzeichnet · durch die folgenden Verfahrensschritte :

a) Bedrucken des Substrats (31) mit einer Widerstandspaste (32) gemäß dem für die Widerstandsbereiche (R) gewünschten Layout mit anschließender Antrocknung,

b) im wesentlichen ganzflächige Beschichtung des Substrates mit einer isolierenden Abdeckpaste (33) unter Aussparung der für die Kontaktierung der Widerstände (R) dienenden Widerstandsanschlußbereiche ($R_a$) mit nachfolgender Antrocknung,

c) Bedrucken mit einer für nachfolgende stromlose Metallisierung sensibilisierten elektrisch leitenden niederohmigen Haftvermittler-Widerstandspaste (34) gemäß dem für die Leiterbahnen (L) einschließlich der im Verfahrensschritt b) unbedeckt gelassenen Widerstandsanschlußbereiche ($R_a$) und die Schaltkontaktstellenbereiche (C) gewünschten Layout,

d) Behandlung der Leiterplatte im chemisch arbeitenden Metallisierungsbad zur stromlosen Metallisierung der im Verfahrensschritt d) mit sensibilisierter Widerstandspaste bedruckten Bereiche (L, $R_a$, C) unter additiver Erzeugung lötbarer Leiterbahnen (L) mit Widerstandsanschlußbereichen ($R_a$) sowie der Kontaktstellenbereiche (C).

8. Verfahren nach Anspruch 7, dadurch gekennzeichnet, daß nach dem Verfahrensschritt c) das Gebilde aus dem mit der Widerstandspaste (32), der Isolierpaste (33) und der sensibilisierten Widerstandspaste (34) bedruckten Substrat eine Stunde lang bei ca. 230 °C ausgehärtet wird.

9. Verfahren nach Anspruch 7 oder 8, dadurch gekennzeichnet, daß in einem auf den Verfahrensschritt d) folgenden Verfahrensschritt die Metallisierung (35) im Bereich der Kontaktstellen (C) und gegebenenfalls im Bereich ausgewählter Teile der Leiterbahnen ($L_c$) mit einer elektrisch leitenden niederohmigen Pyropolymer-Widerstandsschicht als Abrieb- und Oxydationsschutz bedruckt werden.

10. Verfahren nach einem oder mehreren der vorhergehenden Ansprüche, dadurch gekennzeichnet, daß die verschiedenen Bedruckungen im Siebdruckverfahren erfolgen.

11. Verfahren nach einem oder mehreren der vorhergehenden Ansprüche, dadurch gekennzeichnet, daß in einem abschließenden Verfahrensschritt nach Strippen der verbliebenen Photoresistteile, die Leiterplatte ganzflächig mit einem Lötstopplack behandelt wird, unter Aussparung der zum Einlöten äußerer Schaltungsbauteile im Tauchlötverfahren dienenden Lötkontaktstellen.

12. Verfahren nach einem oder mehreren der vorhergehenden Ansprüche, dadurch gekennzeichnet, daß als Substrat (1, 31) ein Phenolharz-, Epoxydharz-, Polyimidharz-Hartpapier oder ein im Spritzgußverfahren hergestelltes Kunststoffsubstrat aus Polyphenylenoxid, Polyphenylensulfid, Polyimid, Polyamidimid oder Polyphenylensulfon verwendet wird.

13. Verfahren nach einem oder mehreren der vorhergehenden Ansprüche, dadurch gekennzeichnet, daß zur Erzeugung der elektrisch leitenden Widerstandsschichten, der elektrisch isolierenden Abdeckschichten und/oder der Haftvermittlerschichten Pasten verwendet werden, die auf einer gemeinsamen, einheitlichen Bindemittelgrundsubstanz aufgebaut und entsprechend der jeweiligen Funktion als Widerstand, Isolierschicht und/oder Haftvermittler modifiziert sind.

14. Verfahren nach Anspruch 13, dadurch gekennzeichnet, daß die einheitliche Bindemittelgrundsubstanz ein organisches Bindemittelsystem auf der Grundlage eines gesättigten Polyesters und Isoporondiisocyanat und einer weiteren Bindemittelkomponente aufweist und neben OH-Gruppen blockierte bzw. maskierte Isocyanatgruppen und einen Epoxydharz-Anteil enthält.

15. Verfahren nach Anspruch 14, dadurch gekennzeichnet, daß die Bindemittelgrundsubstanz als weitere Bindemittelkomponente ein hydroxymethylgruppenhaltiges Acrylamidharz und ein Melaminformaldehydalkydharz enthält.

16. Verfahren nach Anspruch 14, dadurch gekennzeichnet, daß zur Erzeugung einer elektrisch isolierenden Schicht oder als Lötstopplack die Bindemittelgrundsubstanz als weitere Bindelmittelkomponente Polyisocyanat vernetzende Acrylharze und/oder Polyvinylacetalharze enthält.

17. Verfahren nach einem oder mehreren der Ansprüche 13-15, dadurch gekennzeichnet, daß zur Erzeugung von Widerstands- und/oder Haftvermittlerschichten eine Widerstandspaste verwendet wird, welche in die Bindemittelgrundsubstanz Pyropolymer-, Ruß-, Graphit-, Silber- oder Nickelteilchen mit Teilchengrößen kleiner als 6 μm eindispergiert enthält.

18. Verfahren nach einem oder mehreren der vorhergehenden Ansprüche, dadurch gekennzeichnet, daß die Widerstands- (2, 32) und/oder Haftvermittlerpaste (3, 34) zur Sensibilisierung für nachfolgende stromlose Metallisierung einen Katalysatorbestandteil in die Bindemittelgrundsubstanz eindispergiert enthält.

19. Verfahren nach Anspruch 18, dadurch gekennzeichnet, daß der Katalysatorbestandteil katalytisch wirksame Elemente der Gruppen I und VIII des periodischen Systems vorzugsweise in Form organischer oder anorganischer reduzierbarer Verbindungen dieser Elemente enthält.

20. Verfahren nach Anspruch 19, dadurch gekennzeichnet, daß der Katalysatorbestandteil eine Katalysatorsubstanz aus der Gruppe Pd, $PdCl_2$ oder $Cu_2O$ enthält.

21. Verfahren nach einem oder mehreren der Ansprüche 18-20, dadurch gekennzeichnet, daß der Katalysatorbestandteil feuerfeste, mit pyrolytischem Kohlenstoff überzogene Trägerteilchen aus $Al_2O_3$ aufweist, die mit der Katalysatorverbindung bekeimt oder überzogen sind.

22. Verfahren nach Anspruch 21, dadurch gekennzeichnet, daß die Trägerteilchen mit einem kolloidalen Niederschlag der Katalysatorverbindungen überzogen sind.

23. Verfahren nach einem oder mehreren der Ansprüche 18-22, dadurch gekennzeichnet, daß die aus den für stromlose chemische Metallisierung sensibilisierten Pasten hergestellten Schichten vor der Metallisierung im autokatalytisch arbeitenden Metallisierungsbad einer chemischen « Aufrauhungs »-Vorbehandlung zum porösen Aufschluß der Bindemitteloberfläche unterzogen werden.

24. Verfahren nach Anspruch 23, dadurch gekennzeichnet, daß die chemische Aufrauhung der Bindemitteloberfläche durch Behandlung mit verdünnter Schwefelsäure erfolgt.

**Claims**

1. Method for producing printed circuit boards containing integrated therein resistors and/or switch contact points, characterised in that in the additive process the resistors (R) and/or the switch contact point areas (C) are first printed onto a substrate from a resistor paste (2, 32), sensitized for subsequent currentless metallization, in the desired layout, an adhesion promoting layer (3, 34) sensitized for subsequent currentless metallization is then applied to the substrate in a desired layout for the strip conductors (L) and/or for the switch contact points (C) and in that then by treating the printed circuit board in a chemically operating metallizing bath the exposed areas of the adhesion promoting layer (3, 34) are metallized without current, producing the strip conductors (L) and/or the switch contact points in the desired layout.

2. Method according to claim 1, characterised in that the adhesion promoting layer is produced from an electrically insulating resist paste (3) and apart from serving as an adhesion promoting base for the strip conductors (L) also serves to stop off the resistance areas (R).

3. Method according to claim 1, characterised in that the adhesion promoting layer sensitized for currentless metallization and serving as an adhesion promoting base for the strip conductors is produced from an electrically conductive, low-resistance resistor paste (34) and in that before this sensitized adhesion promoting layer is applied, essentially the whole surface of the substrate printed upon with the resistors (R, 32) is coated with a non-sensitized insulating resist layer (33) sparing the resistance connection areas ($R_a$), said layer serving as a resist for the resistors (R, 32) and as a base for the sensitized adhesion promoting layer (34).

4. Method according to claim 1 or 2 for producing printed circuit boards containing integrated therein resistors and/or switch contact points with a fine conductive structure for the strip conductors, using photo-printing methods for delineating the layout of the strip conductors, characterised by the following method steps :

a) printing upon the substrate (1) with a resistor paste (2) sensitized for subsequent currentless metallization in a layout corresponding to the desired resistance areas (R) and contact point areas (C),

b) printing upon essentially the whole surface of the board with an insulating, adhesion-promoting resist paste (3) likewise sensitized for subsequent currentless metallization, sparing the resistance connection areas ($R_a$) and the contact point areas (C),

c) coating the whole surface of the substrate with a photoresist or covering (4) with subsequent selective exposure to light and removal of coating according to the desired layout for the strip conductors (L), the resistance connection areas ($R_a$) and the connection areas ($C_a$) of the contact points (C),

d) treating the printed circuit board in the chemically operating metallizing bath for currentless metallization of the exposed areas of the sensitized, insulating resist layer (3) applied in step b) and of the sensitized resistance layer (2) applied in step a) with additive production of solderable strip conductors (L) with resistance connection areas ($R_a$) and contact point connection areas ($C_a$).

5. Method according to claim 4, characterised in that following step a) heat treatment is carried out at temperatures in the region of approximately 200 °C to approximately 250 °C depending on the type of substrate in order to harden the resistor paste (2).

6. Method according to claim 4 or 5, characterised in that even those areas (C) which correspond to the desired switch contact points are exposed in step c) through corresponding selective exposure to light and removal of coating by the photoresist (4), are metallized in the subsequent step d) and are printed upon in a final step with an electrically conductive low-resistance pyropolymer layer as protection against abrasion and oxidation.

7. Method according to claim 1 or 3 for producing printed circuit boards containing integrated therein resistors and or switch contact points with a strip conductor structure which permits delineation of the strip conductor layout in the screen printing process, characterised by the following method steps :

a) printing upon the substrate (31) with a resistor paste (32) according to the desired layout for the resistance areas (R) with subsequent commencement of drying,

b) coating essentially the whole surface of the substrate with an insulating resist paste (33) sparing the resistance connection areas $(R_a)$ which serve for the bonding of the resistors (R) with subsequent commencement of drying,

c) printing with an electrically conductive, low-resistance adhesion-promoting resistor paste (34), which has been sensitized for subsequent currentless metallization, according to the desired layout for the strip conductors (L), including the resistance connection areas $(R_a)$ left uncovered in step b), and the switch contact point areas (C),

d) treating the printed circuit board in the chemically operating metallizing bath for currentless metallization of the areas (L, $R_a$, C) printed upon in step d) with sensitized resistor paste with additive production of solderable strip conductors (L) with resistance connection areas $(R_a)$ and also the contact point areas (C).

8. Method according to claim 7, characterized in that after step c) the formation of the substrate printed upon with the resistor paste (32), the insulating paste (33) and the sensitized resistor paste (34) is hardened for one hour at approximately 230 °C.

9. Method according to claim 7 or 8, characterised in that in a step of the method following step d) the metallization (35) in the region of the contact points (C) and, if necessary, in the region of selected portions of the strip conductors $(L_c)$ is printed upon with an electrically conductive, low-resistance pyropolymer resistance layer as protection against abrasion and oxidation.

10. Method according to one or several of the preceding claims, characterised in that the various printing actions take place in the screen printing process.

11. Method according to one or several of the preceding claims, characterised in that in a final step of the method after stripping the remaining photoresist portions the whole surface of the printed circuit board is treated with a solder stop-off, sparing the soldering contact points serving to solder in external circuit components in the dip-soldering process.

12. Method according to one or several of the preceding claims, characterised in that a phenolic resin, expoxy resin, polyimide resin impregnated paper or a plastics substrate produced in the injection moulding process from polyphenylene oxide, polyphenylene sulphide, polyimide, polyamidimide or polyphenylene sulphone is used as a substrate (1, 31).

13. Method according to one or several of the preceding claims, characterised in that pastes, which are synthetised on a common, homogeneous basic binding agent substance and which are modified according to the respective function as resistor, insulating layer and/or adhesion promoter, are used to produce the electrically conductive resistance layers, the electrically insulating covering layers and/or the adhesion promoting layers.

14. Method according to claim 13, characterised in that the homogeneous basic binding agent substance has an organic binding agent system based on a saturated polyester and isophoronediisocyanate and a further binding agent component and contains, in addition to hydroxyl groups, blocked or masked isocyanate groups and an epoxy resin constituent.

15. Method according to claim 14, characterised in that the basic binding agent substance contains an acrylamide resin, containing hydroxymethyl groups, and a melamine formaldehyde alkyd resin as further binding agent components.

16. Method according to claim 14, characterised in that for the purpose of producing an electrically insulating layer or as a solder stop-off, the basic binding agent substance contains acrylic resins cross-linking polyisocyanate, and/or polyvinyl acetal resins as further binding agent components.

17. Method according to one or several of claims 13-15, characterised in that a resistor paste, which contains dispersed into the basic binding agent substance pyropolymer, soot, graphite, silver or nickel particles having a particle size of less than 6 $\mu$m, is used to produce resistance and/or adhesion promoting layers.

18. Method according to one or several of the preceding claims, characterised in that the resistor paste (2, 32) and/or adhesion promoting paste (3, 34) contains a catalyst constituent dispersed into the basic binding agent substance for the purpose of sensitization for subsequent currentless metallization.

19. Method according to claim 18, characterised in that the catalyst constituent contains catalytically active elements of groups I and VIII of the periodic system preferably in the form of organic or inorganic reducible compounds of these elements.

20. Method according to claim 19, characterised in that the catalyst constituent contains a catalyst substance from the group Pd, $PdCl_2$ or $Cu_2O$.

21. Method according to one or several of the claims 18-20, characterised in that the catalyst constituent has fireproof carrier particles of $Al_2O_3$ which are coated with pyrolytic carbon and which are germinated or coated with the catalyst compound.

22. Method according to claim 21, characterised in that the carrier particles are coated with a colloidal deposit of the catalyst compounds.

23. Method according to one or several of the claims 18-22, characterised in that the layers produced from the pastes sensitized for currentless, chemical metallization are subjected to chemical « roughening » pretreatment for the porous decomposition of the binding agent surface before metallization in the autocatalytically operating metallizing bath.

24. Method according to claim 23, characterised in that the binding agent surface is roughened chemically through treatment with diluted sulphuric acid.

## Revendications

1. Procédé de fabrication de plaques conductrices contenant des résistances et/ou des zones a contacts de commande, caractérisé en ce que, dans un processus d'addition, initialement les résistances (R) et/ou les zones à contacts de commande (C) sont imprimées sur un substrat conformément à l'agencement désiré à l'aide d'une pâte résistante (2, 32) sensibilisée pour une métallisation ultérieure sans courant, puis une couche d'adhésif (3, 34), sensibilisée pour une métallisation ultérieure sans courant, est déposée sur le substrat suivant un agencement désiré pour les voies conductrices (L) et/ou pour les zones à contacts de commande (C) et ensuite, par traitement de la plaque dans un bain de métallisation opérant chimiquement, les zones dégagées de la couche d'adhésif (3, 34) sont métallisées sans courant, en produisant les voies conductrices (L) et/ou les zones à contacts de commande avec l'agencement désiré.

2. Procédé selon la revendication 1, caractérisé en ce que la couche adhésive est formée d'une pâte de revêtement électriquement isolante (3) et sert en outre de sous-couche adhésive pour les voies conductrices (L) également en vue d'un recouvrement des zones de résistance (R).

3. Procédé selon la revendication 1, caractérisé en ce que la couche adhésive, servant de sous-couche adhésive pour les voies conductrices et sensibilisée pour une métallisation sans courant, est formée d'une pâte résistante (34) électriquement conductrice et de faible valeur ohmique et en ce que, avant le dépôt de cette couche adhésive sensibilisée, le substrat (31) imprimé avec les résistances (R) (32) est recouvert, essentiellement sur toute sa surface, par une couche de revêtement isolante et non sensibilisée (33), en laissant dégagées les zones de liaison de résistance ($R_a$), cette couche servant de revêtement pour les résistances (R, 32) et de support pour la couche adhésive sensibilisée (34).

4. Procédé selon la revendication 1 ou 2, pour la fabrication de plaques conductrices contenant de façon intégrée des résistances et/ou des zones à contacts de commande, avec une finesse structurale de conducteurs des voies conductrices, en utilisant un procédé de photoimpression pour le tracé de configuration des voies conductrices, caractérisé par les étapes opératoires suivantes :

a) impression du substrat (1), avec une pâte résistante (2) sensibilisée pour une métallisation sans courant ultérieure, en un agencement correspondant aux zones résistantes (R) et aux zones à contacts de commande (C) désirées,

b) impression de la plaque, sensiblement sur toute sa surface, avec une pâte de revêtement adhésif isolant (3), sensibilisée également pour une métallisation sans courant ultérieure, en laissant dégagées les zones de liaison de résistances ($R_a$) et les zones d'établissement de contacts (C),

c) revêtement sur toute la surface du substrat, par une substance (4) de photo-réserve ou de revêtement photo-sensible, une exposition à la lumière et un enlèvement de couche étant effectués ensuite sélectivement en correspondance à l'agencement désiré pour les voies conductrices (L), les zones de liaison de résistances ($R_a$) et les parties de liaison ($C_a$) des zones à contacts (C),

d) traitement de la plaque conductrice dans un bain de métallisation, opérant chimiquement, pour une métallisation sans courant des zones exposées de la couche de revêtement isolant (3) sensibilisée et déposée dans l'étape opératoire b) et de la couche résistante (2) sensibilisée et déposée dans l'étape opératoire a), avec formation par addition de voies conductrices brasables (L) comportant des zones de liaison de résistance ($R_a$) et des parties de liaison de zones de contact ($C_a$).

5. Procédé selon la revendication 4, caractérisé en ce que, à la suite de l'étape opératoire a), un traitement thermique est effectué à des températures comprises entre environ 200 °C et 250 °C, en fonction de la nature du substrat, pour durcir la pâte résistante (2).

6. Procédé selon la revendication 4 ou 5, caractérisé en ce que dans l'étape opératoire c), également les parties (C) correspondant aux zones à contact de commandes désirées sont laissées dégagées par une exposition à la lumière et un enlèvement sélectifs correspondants de la couche (4) de photo-réserve, ces zones dégagées étant métallisées dans l'étape opératoire suivante d) et étant imprimées, dans une étape opératoire suivante, avec une couche de pyropolymère électriquement conductrice et de faible valeur ohmique assurant une protection contre l'usure et l'oxydation.

7. Procédé selon la revendication 1 ou 3, pour la fabrication de plaques conductrices contenant de façon intégrée des résistances et/ou des zones à contacts de commande, avec une structure de voies conductrices permettant le tracé de configuration des voies conductrices dans un procédé d'impression par sérigraphie, procédé caractérisé par les étapes opératoires suivantes :

a) impression du substrat (31), avec une pâte résistante (32), en conformité avec l'agencement désiré pour les zones à résistances (R), avec séchage subséquent.

b) revêtement du substrat, essentiellement sur toute sa surface, avec une pâte isolante de recouvrement (33), en laissant dégagées les zones ($R_a$) de liaison de résistances servant à l'établissement du contact avec les résistances (R), avec séchage ultérieur,

c) impression avec une pâte résistante adhésive (34) électriquement conductrice, de faible valeur ohmique, sensibilisée pour une métallisation sans courant ultérieure en conformité avec l'agencement désiré pour les voies conductrices (L), y compris les zones de liaison de résistances ($R_a$) laissées dégagées dans l'étape opératoire b) et les zones à contacts de commande (C).

d) traitement de la plaque conductrice dans un bain de métallisation, opérant chimiquement, pour une métallisation sans courant des zones (L, $R_a$, C) imprimées dans l'étape opératoire d) avec une pâte résistante sensibilisée, en produisant par addition des voies conductrices brasables (L) avec des zones de liaison de résistances ($R_a$) ainsi que les zones à contacts de commande (C).

8. Procédé selon la revendication 7, caractérisé en ce que, après l'étape opératoire c), la structure formée par le substrat imprimé avec la pâte résistante (32), la pâte isolante (33) et la pâte résistante sensibilisée (34), est durcie pendant 1 heure à environ 230 °C.

9. Procédé selon la revendication 7 ou 8, caractérisé en ce que, dans une étape opératoire suivant l'étape opératoire d), la partie métallisée (35) est imprimée, dans la région des zones de contact (C) et le cas échéant dans la région de parties sélectionnées des voies conductrices ($L_c$), avec une couche résistante de pyropolymère électriquement conductrice, de faible valeur ohmique, servant de protection contre l'usure et l'oxydation.

10. Procédé selon l'une ou plusieurs des revendications précédentes, caractérisé en ce que les différentes opérations d'impression sont effectuées par un procédé d'impression par sérigraphie.

11. Procédé selon l'une ou plusieurs des revendications précédentes, caractérisé en ce que,. dans une étape opératoire suivante, après enlèvement des parties photosensibles subsistantes, la plaque conductrice est traitée sur toute sa surface avec une laque d'arrêt de brasure, en laissant dégagées les zones de contact servant au brasage de composants extérieurs de circuit dans un procédé de brasage par immersion.

12. Procédé selon l'une ou plusieurs des revendications précédentes, caractérisé en ce qu'on utilise comme substrat (1, 31) un papier durci à l'aide d'une résine phénolique, d'une résine époxyde, d'une résine de polyimide ou bien un substrat en matière plastique fabriqué par un procédé de moulage par injection et formé d'oxyde de polyphénylène, de sulfure de polyphénylène, de polyimide, de polyamidimide ou de polyphénylène-sulfone.

13. Procédé selon l'une ou plusieurs des revendications précédentes, caractérisé en ce que, pour produire les couches résistantes électriquement conductrices, les couches de revêtement électriquement isolantes et/ou les couches adhésives, on utilise des pâtes, qui contiennent une substance de base de liant commune et homogène et qui sont modifiées en correspondance à la fonction respective de résistance, de couches isolantes et/où d'adhésif.

14. Procédé selon la revendication 13, caractérisé en ce que la substance de base de liant homogène comporte un système de liant organique à base d'un polyester saturé et d'isocyanate d'isophorone ainsi que d'un autre composant de liant et contient en plus des groupes OH, des groupes isocyanates loqués ou masqués et une fraction de résine époxyde.

15. Procédé selon la revendication 14, caractérisé en ce que la substance de base de liant contient comme autre composant de liant une résine d'acrylamide contenant des groupes hydroxyméthyles et une résine alkyde mélamine/formaldéhyde.

16. Procédé selon la revendication 14, caractérisé en ce que, pour la production d'une couche électriquement isolante ou bien comme laque d'arrêt de brasure, la substance de base de liant contient comme autre composant de liant des résines acryliques réticulant le polyisocyanate et/ou des résines d'acétate de polyvinyle.

17. Procédé selon l'une ou plusieurs des revendications 13 à 15, caractérisé en ce que, pour produire les couches résistantes et/ou adhésives, on utilise une pâte résistante qui contient dans la substance de base de liant des particules de pyropolymère, de suie, de graphite, d'argent ou de nickel en dispersion et d'une grosseur inférieure à 6 micromètres.

18. Procédé selon l'une ou plusieurs des revendications précédentes, caractérisé en ce que la pâte résistante et/ou adhésive (3, 34) contient, pour une sensibilisation en vue d'une métallisation sans courant ultérieure, un composant-catalyseur qui est dispersé dans la substance de base de liant.

19. Procédé selon la revendication 18, caractérisé en ce que le composant-catalyseur contient des éléments catalytiquement actifs des groupes I et VIII de la Classification Périodique, de préférence sous forme de composés organiques ou minéraux réductibles de ces éléments.

20. Procédé selon la revendication 19, caractérisé en ce que le composant-catalyseur contient une substance-catalyseur faisant partie du groupe comprenant Pd, $PdCl_2$ ou $Cu_2O$.

21. Procédé selon l'une ou plusieurs des revendications 18 à 20, caractérisé en ce que le composant-catalyseur contient des particules solides d'$Al_2O_3$ de support, revêtues de carbone pyrolytique et qui sont imprégnées ou revêtues du composé-catalyseur.

22. Procédé selon la revendication 21, caractérisé en ce que les particules de support sont revêtues d'un précipité colloïdal des composés-catalyseurs.

23. Procédé selon l'une ou plusieurs des revendications 18 à 22, caractérisé en ce que les couches formées à partir des pâtes sensibilisées pour une métallisation chimique sans courant sont soumises, avant la métallisation dans un bain de métallisation opérant de façon auto-catalytique, à un pré-traitement chimique d'« établissement de rugosité » pour donner une structure poreuse à la surface de liant.

24. Procédé selon la revendication 23, caractérisé en ce que l'établissement chimique de rugosité de la surface de liant est réalisé par traitement avec de l'acide sulfurique dilué.

**0 071 003**

## Fig. 1

Fig. 1a

Fig. 1b

Fig. 1c

Fig. 1d

Fig. 1e

Fig. 1f

Fig.2

Fig. 3

R    32    31

Fig. 3a

33   Rₐ   33    Rₐ    33     33

Fig. 3b

34   L   Rₐ   R   Rₐ   L   C₁   C   C₂   34
33                   33
31

Fig. 3c

Rₐ    C
35   L   35   L   C₁   C₂   L   35

Fig. 3d

Fig. 4    C₁   C   C₂
L    L   36      L_c   36   35
34
33

Fig. 5    Fig. 3e

Fig. 4

(Festwiderstand R in Leitungsmuster L integriert)

0 071 003

# Fig. 5

(Schaltkontaktstelle C in Leitungsmuster L integriert)

Isolierschicht 33
+ Substrat 31

0 071 003